# EUROPEAN PATENT APPLICATION

(11) **EP 4 712 345 A1**
(43) Date of publication of application: **18.03.2026**
(21) Application number: 24200067.7
(22) Date of filing: 12.09.2024
(51) Int. Cl.: H03H 9/05, H03H 9/10, H03H 9/19

(54) **ZT-QUARTZ RESONATOR**

(71) Applicant: Micro Crystal SA, 2540 Grenchen (CH)
(72) Inventor: DALLA PIAZZA, Silvio, 2610 St-Imier (CH); STAUB, Felix, 3425 Koppigen (CH)
(74) Representative: ICB SA

(57) **Abstract**

One aspect of the invention is related to the resonator comprising:
- a resonator plate having a thickness, and a surface having a maximum length and a width, wherein the resonator plate is a ZT-cut quartz, and ;
- a frame comprising a C-shaped portion comprising a first arm and a second arm extending at least partially about the lateral edges of the resonator plate and wherein each of the first arm and second arm is connected to the resonator plate by means of tethers.

## Description

### Technical field

The present invention is related to a miniature quartz resonator machined from a ZT-cut quartz and configured to oscillate in a length-extensional contour mode along an edge of a plate.

### Background

ZT-quartz resonators have been described in prior art documents such as FR2435855, FR2521782, FR2634067.

The cut angle of a ZT-resonator is chosen in order to achieve a vanishing first-order frequency-temperature coefficient and a negligible coupling to the surface shear mode and the extensional mode along the other edge of the plate. Different ZT-cuts featuring similar properties can be obtained by prior rotation of angle ψ around the Z-axis, followed by a rotation ϕ around the X' axis and possibly around the Z' axis normal to the plane of the plate by the angle θ. A common cut is ψ = 90°, so the second rotation will be around X' = Y with ϕ = 26.5° and θ = 20° around Z'. This cut is referred to as ZTY. The probably most simple cut of the ZT-family is a single rotation around X with ϕ = 24°, referred to as ZTX.

By properly choosing the aspect ratio of the plate, the second order temperature coefficient becomes zero as well due to residual coupling between the (extensional) modes. Consequently a third-order frequency-temperature behaviour is obtained. The third-order temperature coefficient is about two times smaller than for AT-cut resonators. Moreover, for a frequency given, the ZT can be made significantly smaller than an AT.

For typical dimensions of a ZT, its resonance is in the range between 1 and 20 MHz.

As a contour mode is sensitive to impacts on its periphery, the production process has to assure a precise control of the shape. Furthermore, special care has to be taken for anchoring. Anchors keep the resonator in place while assuring good decoupling from the package in order to maintain the high quality factor and the outstanding thermal properties of the ZT-Resonator.

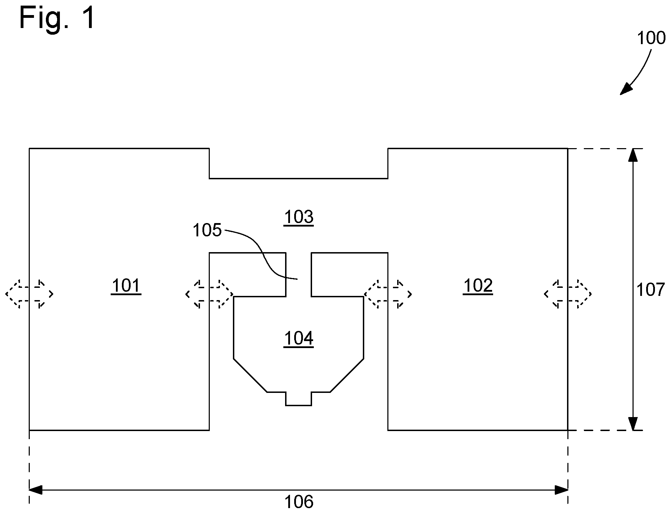

In prior realisation anchoring was performed by means of resonant arms, which minimises disturbance of the mode (fig. 1). However, the geometry of the anchors is very critical too.

The figure 1 shows an example of a ZT-cut quartz resonator 100 of prior art comprising a first resonator plate 101 and a second resonator plate 102 linked together by a resonant arm 103. The resonant arm 103 is linked to a mounting portion 104 through a suspension arm 105. Each of the first resonator plate 101, second resonator plate 102, resonant arm 103, mounting portion 104 and suspension arm 105 are coplanar. One face of the each resonator plate carries a first electrode (not represented) and the opposite face of each of the resonator plate carries a second electrode (not represented), wherein both electrodes are electrically coupled to an alternating electric field generator (not represented). The first and second electrodes are designed and arranged such as to generate oscillations of the two resonator plates in the direction of their width as represented by the dashed arrows. The two resonator plates are balanced on both sides of the resonant arm and the mounting portion. The mounting portion is arranged in between the two resonator plates to minimize the width of the resonator. Due to the presence of two resonator plates connected by a resonant arm, the length 106 of a resonator can be relatively long, e.g. 3850 µm length, while the width 107 of the resonator plate is also relatively long, e.g. 2024 µm.

There is a need to miniaturize ZT-cut quartz resonators, however miniaturization is limited by the complex design of such resonators which become difficult to machine at lower size. Additionally, resonant arm and support arm must remain sufficiently wide to stand mechanical constraints generated by cumbersome resonator plates. The symmetry of the resonant structure has to be well controlled in order to minimize energy loss and thus damping in the mounting portion.

### Summary of the invention

The present invention aims to provide an alternative design of a ZT-cut quartz resonator which overcome the challenging constraints linked to miniaturization of such resonators.

According to a first aspect, the resonator comprises :
- a resonator plate having a thickness, and a surface having a maximum length and a width, wherein the resonator plate is a ZT-cut quartz, and ;
- a frame comprising a C-shaped portion comprising a first arm and a second arm extending at least partially about the lateral edges of the resonator plate and wherein each of the first arm and second arm is connected to the resonator plate by means of tethers.

It is defined a nodal plane orthogonal to the surface of the resonator plate and passing through a central longitudinal axis of the resonator plate and wherein the tethers pass through the nodal plane.

Preferably, the resonator plate is configured to oscillate on both sides of the nodal plane in the direction of its width and the C-shaped portion of the frame is spaced from the resonator plate such as to prevent the resonator plate to enter into contact with the frame while the resonator plate is oscillating and such as to guarantee the decoupling of the plate with the frame.

Preferably, the resonator plate comprises at least two electrodes separated from each other and electrically coupled to mounting pads arranged on the frame, the electrodes being arranged such as to create an electric field between at least two surfaces of the resonator plate, on both sides of the nodal plane.

Preferably, a first electrode and a second electrode are arranged on the resonator plate such as to provide an alternating deformation of the resonator plate along the width of the resonator plate when the first electrode and the second electrode are coupled to an alternative voltage creating an alternative electric field between the two electrodes.

Preferably, a first tether extends from a first side of the resonator plate to a first arm of the C-shaped portion of the frame, and a second tether extends from a second side of the resonator plate to a second arm of the C-shaped portion of the frame.

Preferably, the tethers are integral with the resonator plate and the frame.

Preferably, the resonator plate has a maximum length, lateral edges and longitudinal edges, and the maximum length is on both sides of the nodal plane at the furthermost distance relative to the nodal plane, or at a distance proximate to the longitudinal edges.

Preferably, the resonator plate comprises a shortest length, the shortest length extending proximate to a location in between :
- a first corner formed between a first tether and a first lateral edge of the resonator plate, and ;
- a second corner formed between a second tether and a second lateral edge of the resonator plate.

Preferably, the shortest length is at least 90% of the maximum length, preferably at least 95% of the maximum length, more preferably at least 99% of the maximum length.

Preferably the shortest length is on both sides of the nodal plane.

In some embodiments, a lateral edge located between a first extremity proximate to a tether and a second extremity proximate to a longitudinal edge forms an inclination angle of 10° or less, preferably 5° or less with an axis orthogonal to the nodal plane.

Preferably, the resonator plate is substantially symmetrical with respect to its central longitudinal axis (i.e. passing by the nodal plane) and with respect to its median width axis (i.e. orthogonal to the nodal plane).

Preferably, the frame has a frame thickness such that the resonator thickness is comprised between 25% and 100%, preferably between 25% and 75%, more preferably between 25% and 50% of the frame thickness.

Preferably, the resonator plate has a maximum length inferior or equal to 3000 µm, preferably 2000 µm or less, preferably inferior or equal to 1000 µm, more preferably inferior or equal to 600 µm.

Preferably, the tethers have a length comprised between 10 µm and 300 µm, preferably 20 to 150 µm, more preferably 50µm to 100 µm.

The width of the tether is preferably 20% or less of the width of the resonator plate.

The thickness of the tether is comprised between 50% to 150% of the thickness of the resonator plate.

Preferably, the resonator plate has a maximum width, such that the ratio (width)/(maximum length) is from between 0.4 to 0.8, preferably from 0.5 to 0.7.

Preferably, the frame comprises a mounting portion comprising a first mounting pad and a second mounting pad, coupled to the first electrode and second electrode respectively.

Preferably, the maximum length of the frame is inferior or equal to 4000 µm, preferably inferior or equal to 2500 µm, more preferably inferior or equal to 1500 µm.

Preferably, the maximum thickness of the frame TF is inferior or equal to 200 µm, preferably inferior or equal to 150 µm, more preferably inferior or equal to 120 µm.

According to a second aspect, the present invention is related to a process of manufacturing of a resonator as described above, wherein the process comprises the steps of :
- providing a ZT-cut wafer;
- defining a resonator shape emplacement on the wafer, wherein the resonator shape emplacement includes a resonator frame shape emplacement, a resonator plate shape emplacement and tethers shape emplacements, wherein the tethers shape emplacements are positioned along a central longitudinal axis of the resonator plate shape emplacement and links the lateral sides of the resonator plate shape emplacement to the resonator frame shape emplacement;
- etching a portion of the wafer to obtain the contours of a resonator plate with tethers on both lateral sides of the resonator plate and such that the tethers remains integral with the resonator frame ;
- depositing:
   ∘ at least two separated electrodes on the resonator plate such that a first electrode has a main portion arranged on one side of a plane passing through the tethers and a second electrode has a main portion arranged on the other side of the plane passing through the tethers ;
   ∘ two mounting pads on the resonator frame emplacement, and ;
   ∘ connecting tracks connecting each electrode to a respective mounting pad, and;
- etching the contours of the resonator frame emplacement such as to obtain a resonator.

In one embodiment of the manufacturing process, the process comprises the steps of :
- applying a first mask on the surface of the wafer for covering a first surface destined to form a frame with a C-shaped portion, and leaving a portion of the surface of the wafer uncovered destined to form a thinner planar portion of the wafer;
- Chemically wet etching the uncovered surface of the wafer to obtain a thinner planar portion ;
- Applying a second mask on the planar portion, wherein the second mask has the shape of a resonator plate with tethers extending from the resonator plate shape to the C-shaped portion of the frame ;
- Chemically wet etching the remaining uncovered surface of the wafer to form the contours of the resonator plate and the tethers.

In one alternative embodiment, the process of manufacturing the resonator further comprises the steps of :
- applying a first mask on the surface of the wafer for covering a first surface destined to form a frame with a C-shaped portion, and leaving a portion of the surface of the wafer uncovered destined to form a thinner planar portion of the wafer;
- Chemically wet etching the uncovered surface of the wafer to obtain a thinner planar portion ;
- Cutting by femtosecond laser or by deep reactive ion etching (DRIE) the contour of a resonator plate with tethers extending from the resonator plate to the C-shaped portion of the frame.

In one alternative embodiment, the step of etching a portion of the wafer to obtain the contours of a resonator plate with tethers on both lateral sides of the resonator plate and such that the tethers remains integral with the resonator frame is performed by cutting by femtosecond laser or by deep reactive ion etching (DRIE).

### Brief description of the drawings

The goals, advantages and features of the invention will appear upon reading the following description, given solely by way of non-limiting example, and made with reference to the annexed drawings, in which :
- the figure 1 shows an embodiment of a resonator according to the prior art ;
- the figure 2 shows a top view of an embodiment of a resonator according to the present invention ;
- the figure 3 shows a side view of an embodiment of a resonator according to the present invention ;
- the figure 4a to 4f show various schematic cross section views along the width of resonator plates with different arrangements of electrodes ;
- the figure 5 show a schematic cross section view along the width of a resonator plate with a piezoelectric assembly ;
- the figures 6a to 6d show schematic top views of resonator plates according to various embodiments of the invention ;
- the figure 7 shows an image of simulation of deformations in a resonator according to an embodiment of the invention when submitted to an alternative electrical field ;
- the figure 8a shows a top view of an embodiment of a preformed resonator, the figure 8b shows a top view of an embodiment of a resonator obtained from a manufacturing process according to a first embodiment of a manufacturing process, and the figure 8c shows a top view of another embodiment of a resonator obtained from a manufacturing process according to a second embodiment of a manufacturing process ;
- the figure 9a shows a top view of another embodiment of a preformed resonator and the figure 9b shows a top view of a resonator obtained from a manufacturing process according to a third embodiment of a manufacturing process.

It is to be noted that unless stated otherwise, the drawings are not up to scale and that other variation of the design of the resonator are possible within the spirit of the present invention.

### Detailed description of the invention

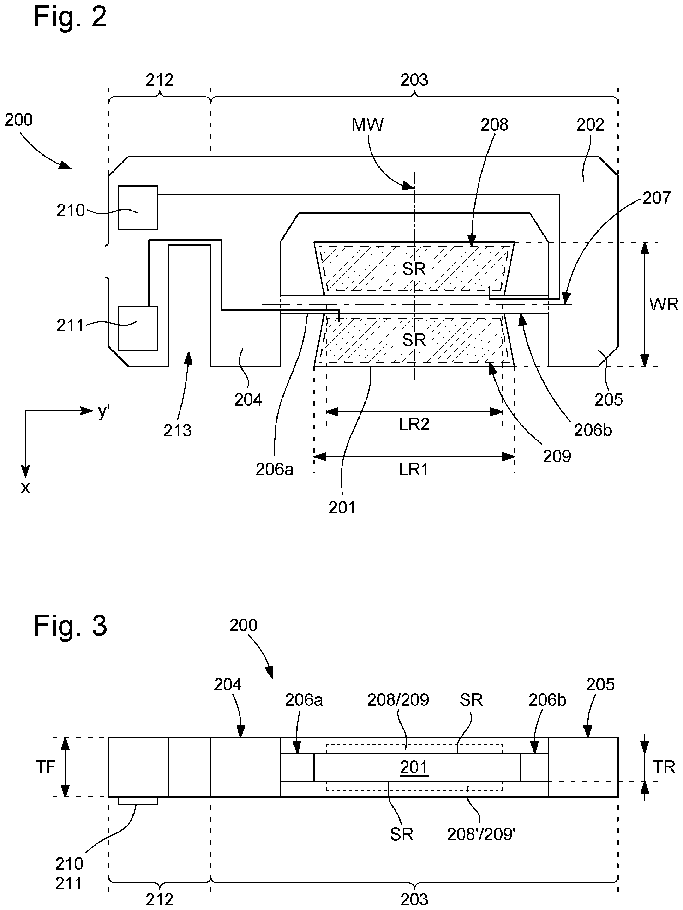

The present invention will be described in more details here below with the support of the figures 2 and 3 which show an embodiment of a resonator 200 comprising :
- a resonator plate 201 having a thickness TR, and a surface SR having lateral edges and longitudinal edges, a maximum length LR1 and a width WR, wherein the resonator plate 201 is a ZT-cut quartz ;
- a frame 202 comprising a C-shaped portion 203 comprising a first arm 204, and a second arm 205 extending at least partially about the lateral edges of the resonator plate and wherein each arm 204, 205 is connected to the resonator plate by means of tethers 206a, 206b.

Advantageously, the frame is made of quartz. Preferably, the tethers are also made of quartz. For the ease of fabrication, the whole resonator 200 is made in one piece from a ZT-cut quartz wafer. A certain number of resonators can be placed per wafer. The shape of the resonator 200 can be obtained for example by chemical wet etching or by deep reactive ion etching, or by the method described in document WO2013/092920, or by femtosecond laser-induced chemical etching as described in Linden et al. Microsystems & Nanoengineering (2023) 9:38.

The term « surface » when used in relation with the resonator plate, unless stated otherwise, refers to the greatest surface of the resonator plate, on both sides of the plate.

The term « C-shaped portion » refers to a portion of the frame forming a C, wherein the portion preferably comprises a sub-portion having a first end and a second end to which are connected respectively a first arm 204 and a second arm 205 pointing towards the same direction. The sub-portion, the first arm and the second arm are preferably straight. Preferably, the sub-portion forms an angle of 90° with the first arm and the second arm.

It is defined a nodal plane 207 orthogonal to the surface SR of the resonator plate 201 and passing through a central longitudinal axis of the resonator plate 201 and wherein the tethers 206a, 206b pass through the nodal plane 207. The nodal plane 207 is a fictive plane crossing orthogonally the resonator plate and wherein the amplitudes of vibration are at their minimum or zero when the resonator plate is oscillating under the influence of an alternating electric field.

The resonator plate 201 is configured to oscillate on both sides of the nodal plane 207 in the direction of its width WR. The terms «oscillating », « oscillate », or « oscillation », in the context of the present invention refers to a change of shape of a plate made of a quartz crystal having piezoelectric properties under the application of an alternative electrical field such that the plate periodically extends and contracts along its width on both sides of a nodal plane.

The C-shaped portion 203 of the frame 202 is spaced from the resonator plate 201 such as to prevent the resonator plate 201 to enter into contact with the frame 202 while the resonator plate 201 is oscillating. Preferably, the C-shaped portion 203 of the frame is spaced from the plate by a distance of at least 1 µm, preferably 10 µm, 20 µm, preferably at least 50 µm, more preferably at least 75 µm.

The resonator plate 201 comprises at least a first electrodes 208, and a second electrode 209 separated from each other and electrically coupled respectively to a first mounting pad 210, and to a second mounting pad 211 arranged on the frame 202. The electrodes are arranged such as to create an electric field between at least two surfaces of the resonator plate, on both sides of the nodal plane.

A first electrode 208 and a second electrode 209 are arranged on the resonator plate such as to provide a deformation of the resonator plate along the width of the resonator plate, when the first electrode and the second electrode are coupled to an alternative voltage creating an alternative electric field between the two electrodes. The configuration of the electrodes can be optimized in order to maximize piezoelectric coupling to the resonance mode while suppressing unwanted modes.

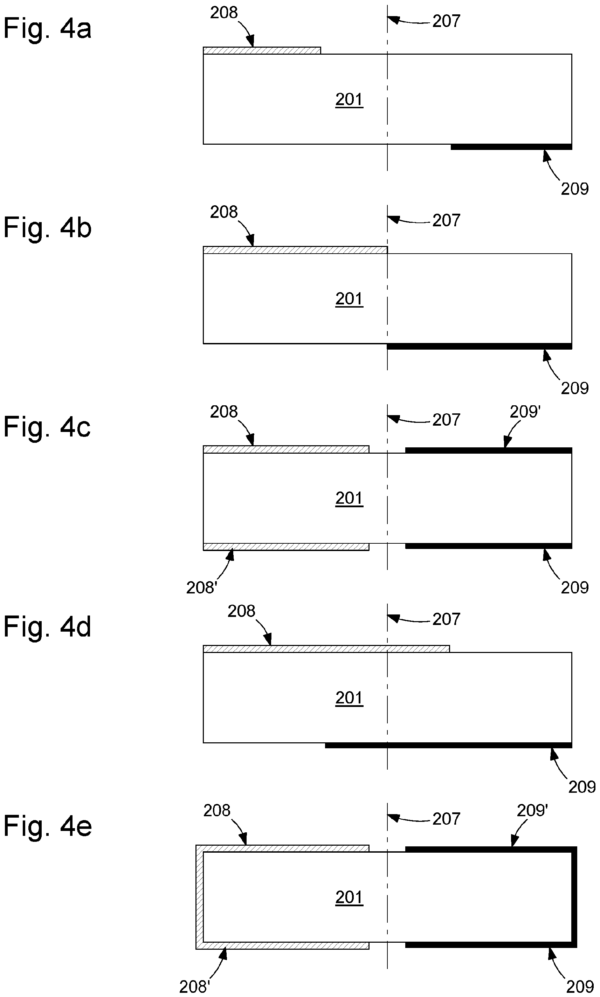

Fig. 4a to 4f show various possible configurations of electrodes on the resonator plates 201. In fig. 4a, a first electrode 208 is on a first side of the resonator plate 201 and partially covers the surface of the resonator plate at a first side of the nodal plane 207, and a second electrode 209 is on the opposite side of the resonator plate 201 and partially covers the surface of the resonator plate at the second side of the nodal plane 207. The first electrode 208 and the second electrode 209 have opposite polarities.

In fig. 4b, a first electrode 208 is on a first side of the resonator plate 201 and covers totally the surface of the resonator plate at a first side of the nodal plane 207, and a second electrode 209 is on the opposite side of the resonator plate 201 and covers totally the surface at the second side of the nodal plane 207. The first electrode 208 and the second electrode 209 have opposite polarities.

In fig. 4c, a couple of first electrodes 208, 208' are on both sides of the resonator plate 201 and partially covers the surface of the resonator plate at a first side of the nodal plane 207, and a couple of second electrodes 209, 209' are on both sides of the resonator plate 201 and partially covers the surface of the resonator plate at a second side of the nodal plane 207. The couple of first electrodes 208, 208' have the same polarity and must be separated by a gap from the couple of second electrodes 209, 209' both having an opposite polarity relative to the couple of first electrodes 208, 208'.

In fig. 4d, a first electrode 208 is on a first side of the resonator plate 201 and covers totally the surface of the resonator plate at a first side of the nodal plane 207, and partially the surface of the resonator plate at the second side of the nodal plane 207. A second electrode 209 is on the opposite side of the resonator plate 201 and covers totally the surface at the second side of the nodal plane 207, and partially the surface at the first side of the nodal plane 207. The first electrode 208 and the second electrode 209 have opposite polarities.

In Fig. 4e, a first electrode 208 extends from one side of the resonator plate to the other side of the resonator plate trough a trench of the resonator plate in a first side of the nodal plane 207, and a second electrode 209 extends from a first side of the resonator plate to the other side of the resonator plate through an opposite trench of the resonator plate, on the other side of the nodal plane 207. The first electrode 208 and the second electrode 209 are separated from each other by a gap and have opposite polarities.

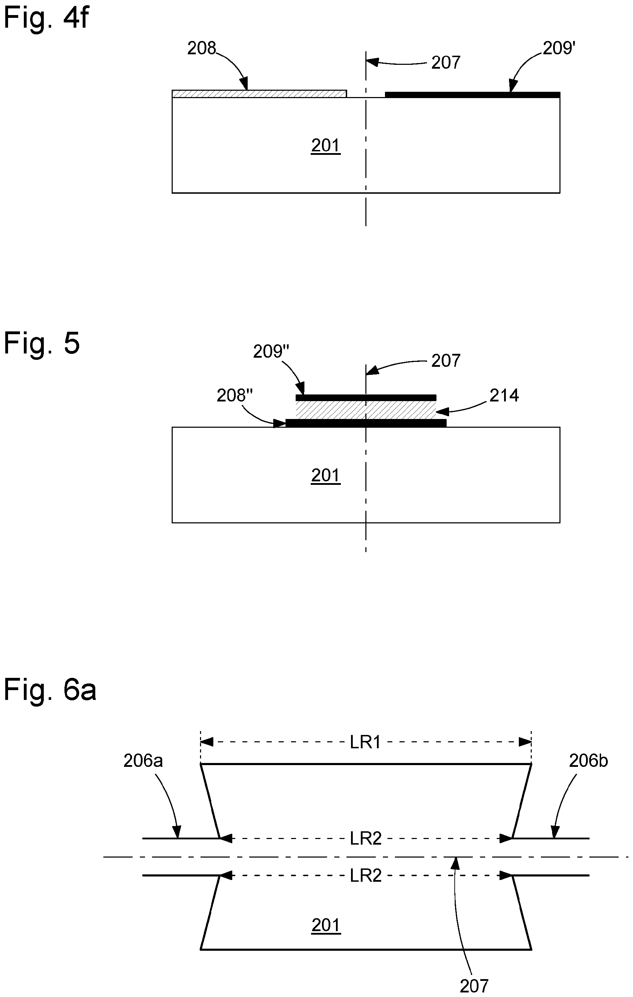

In fig. 4f, a first electrode 208 is on a first side of the resonator plate 201 and partially covers the surface of the resonator plate at a first side of the nodal plane 207, and a second electrode 209' is on the same side of the resonator plate 201 and partially covers the surface of the resonator plate at the second side of the nodal plane 207. The first electrode 208 and the second electrode 209' have opposite polarities. A similar arrangement is obtained placing the electrodes on the second side of the resonator plate 201.

The first mounting pad 210 and the second mounting pad 211 are configured to be coupled to an alternative electric field generator, i.e. an oscillator circuit.

In an alternative embodiment as presented in fig. 5, a piezoelectric assembly is mounted on at least one surface of the resonator plate 201 and extends on both sides of the nodal plane 207. The first piezoelectric assembly comprises a first electrode 208" over the surface of the resonator plate, a piezoelectric layer 214 over the first electrode 208", and a second electrode 209" over the piezoelectric layer 214. The first electrode 208" is coupled to the first mounting pad 210 and the second electrode 209" is coupled to the second mounting pad 211 with opposite polarities.

As shown in fig. 3, the tethers 206a, 206b are arranged on both sides of the resonator plate 201. A first tether 206a extends from the first arm 204 to the resonator plate 201, and a second tether 206b extends from the second arm 205 of the C-shaped portion 203 of the frame 202 to the resonator plate 201. The tethers 206a, 206b are preferably integral with the frame 202, and the resonator plate 201. The tether 206a, 206b and the resonator plate 201 may have a thickness TR equal or inferior to the thickness TF of the frame 202. Preferably, the tethers have a length comprised between 10 µm and 300 µm, preferably 20 to 150 µm, more preferably 40 µm to 100 µm. The width of the tether is preferably 25% or less of the width of the resonator plate. The thickness of the tether is comprised between 50% to 150% of the thickness of the resonator plate. In a preferred embodiment, the tethers have a length comprised between 40 µm and 100 µm, a width inferior to 20% of the width of the resonator plate, and a thickness comprised between 80% and 120% of the thickness of the resonator plate, preferably a thickness of about 100% of the thickness of the resonator plate.

The first electrode 208 or the couple of first electrode 208, 208' are connected to the first mounting pad 210 by a wiring or signal track passing through a first tether 206a and through the frame 202. The second electrode 209 or the couple of second electrodes 209, 209' are connected to the second mounting pad 211 by a wiring or a signal track passing through a second tether 206b and through the frame 202. The term « passing through » also include passing on the surface of the tethers or the frame, the wiring or signal track that can be optionally insulated by an adequate insulating layer known by the skilled person.

The first electrode 208, or the couple of first electrodes 208, 208', the second electrode 209 or the couple of second electrodes 209, 209' are provided on the resonator plate 201 by partial metallization of the resonator plate, for example by the techniques of chemical vapor deposition, physical vapor deposition, a vacuum deposition method, sputtering method or any other adequate method known to the skilled in the art. The electrodes can be made of any metal or alloy, such as but non-limited to copper, zinc, chromium/gold or platinum.

In order to minimize coupling between the resonator and its exterior (frame, package), the thickness of the resonator plate 201 and of the tethers 206a, 206b is reduced with respect to the frame.

The resonator plate 201 has a thickness TR that can be comprised between 25 µm and 100 µm, advantageously inferior or equal to 75 µm or inferior or equal to 50 µm.

The tethers 206a, 206b may have the same thickness as the thickness of the resonator plate 201.

The reduction of the thickness of the resonator plate 202 and the thickness of the tethers 206a, 206b yields the following advantages :
- reduction of the ratio thickness/width of the plate 201, which improves the mode-shape and allows for smaller footprints ;
- reduction of the moving mass with respect to the frame 202, which reduces transfer of residual movement from the plate 201 to the frame 202 (touch-effect) ;
- improved decoupling due to smaller cross-section of the tethers 206a, 206b.

Although the tethers 206a, 206b join the resonator plate 201 at the nodal plane 207, they modify the effective shape of the resonator plate 201 and consequently the frequency-temperature behaviour. This can be compensated for by modifying the shape of the resonator plate 201 such that the resonator plate 201 comprises a second length LR2 shorter than the maximum length LR1 of the resonator plate 201, the second length LR2 extending proximate to a location in between :
- a first corner formed between a first tether and a first lateral edge of the resonator plate, and ;
- a second corner formed between a second tether and a second lateral edge of the resonator plate.

The term "proximate" in the context herein refers to a distance to at most 25% of the shortest distance separating the tether from a lateral edge of the resonator plate.

The second length LR2 is preferably the shortest length of the resonator plate and is at least 90% of the maximum length LR1 of the resonator plate 201, preferably at least 95% of the maximum length LR1, more preferably at least 99% of the maximum length LR1.

The resonator plate 201 is substantially symmetrical with respect to its median width axis MW and with respect to its central longitudinal axis (or the nodal plane 207). By "substantially symmetrical" is understood that small deviations from perfect geometrical symmetry may be necessary in order to compensate for small residues of asymmetries forming due to anisotropic etching and etch residues occurring in chemical wet-etching processes.

The maximum length LR1 of the resonator plate is advantageously situated at the longitudinal edges of the resonator plate or at a distance proximate the longitudinal edges, for example at a distance to the longitudinal edges of less than 10% of the width of the plate. In this context, the term "distance proximate to the longitudinal edge" refers preferably to a distance of 50% or less of the distance separating the longitudinal edge from the nodal plane.

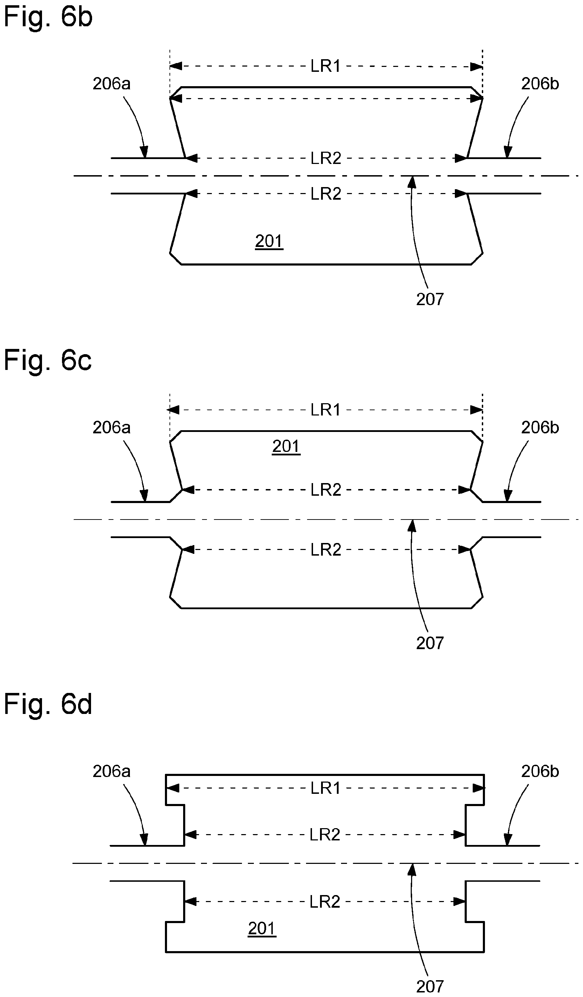

Example of embodiments of resonator plates with tethers are shown in fig. 6a to 6c. In Fig.6a, each of the corners of the plate and the corners between the lateral edges and the tethers are sharp. In fig. 6b, the corners between the longitudinal edges and the lateral edges are chamfered. In Fig. 6c, the corners between the tethers and the lateral edges may comprise etch residues so that the shortest length LR2 of the resonator plate is a bit away from the tethers but still a location proximate the tethers.

Fig. 6d shows an alternative embodiment of a resonator plate with tethers, wherein the lateral edges of the resonator plate form a notch between a portion of the resonator plate having a maximum length LR1 and the tethers 206a, 206b, such as to form a second portion of minimum length LR2.

The frame 202 has a frame thickness TF and the resonator thickness TR is comprised between 25% and 100%, preferably between 25% and 75%, preferably between 25% and 60%, more preferably between 30% and 50% of the frame thickness TF.

Advantageously, the maximum thickness of the frame TF is inferior or equal to 200 µm, preferably inferior or equal to 150 µm, more preferably inferior or equal to 120 µm.

The resonator plate 201 has a maximum length inferior or equal to 300 µm, preferably 2000 µm or less, preferably inferior or equal to 1000 µm, more preferably inferior or equal to 600 µm and has a ratio width/length comprised from 0.4 to 0.8, preferably from 0.5 to 0.7.

The frame 202 comprises a mounting portion 212 comprising the first mounting pad 210 and the second mounting pad 211, the mounting portion 212 extending substantially parallel to the first and second arms 204, 205 of the C-shaped portion 203, the mounting portion 212 being connected to the C-shaped portion 203 and forming a notch 213 with the C-shaped portion 203 as shown in fig. 2. Alternatively, the mounting portion is on the C-shaped portion. For example the first mounting pad can be mounted on a first arm opposite to the first tether, and the second mounting pad can be mounted on the second arm opposite to the second tether. In another embodiment, the first mounting pad and the second mounting pad can be mounted on the portion of the frame joining the first and second arm.

The maximum length of the frame 202 is inferior or equal to 4000 µm, preferably inferior or equal to 2500 µm, preferably inferior or equal to 1500 µm, more preferably inferior or equal to 1500 µm.

The shape of the frame 202 fits into a rectangle and the corners of the frame 202 can be chamfered to minimize damages that can results from having sharp corners during manipulation of the resonator. The resonator plate 201 may also have its corners chamfered for the same reasons.

The resonator plate 201, the frame 202 and the tethers 206a, 206b can be obtained by photolithographic manufacturing techniques known in the art, such as for example a technique of chemical wet etching or the technique of deep ion reactive etching, or a combination thereof or combined with laser cutting.

In a second aspect of the invention, a process for manufacturing a resonator according to a first embodiment comprises the steps of :
- Providing a wafer of ZT-cut quartz and applying a first mask on the surface of the wafer for covering a first surface destined to form a frame 202 with a C-shaped portion, and leaving a portion of the surface of the wafer uncovered destined to form a thinner planar portion 199 of the wafer;
- Chemically wet etching the uncovered surface of the wafer to obtain a thinner planar portion 199 ;
- Applying a second mask on the planar portion 199, wherein the second mask has the shape of a resonator plate with tethers extending from the resonator plate shape to the C-shaped portion of the frame 202, and ;
- Chemically wet etching the remaining uncovered surface of the wafer to form the contours of the resonator plate and the tethers.

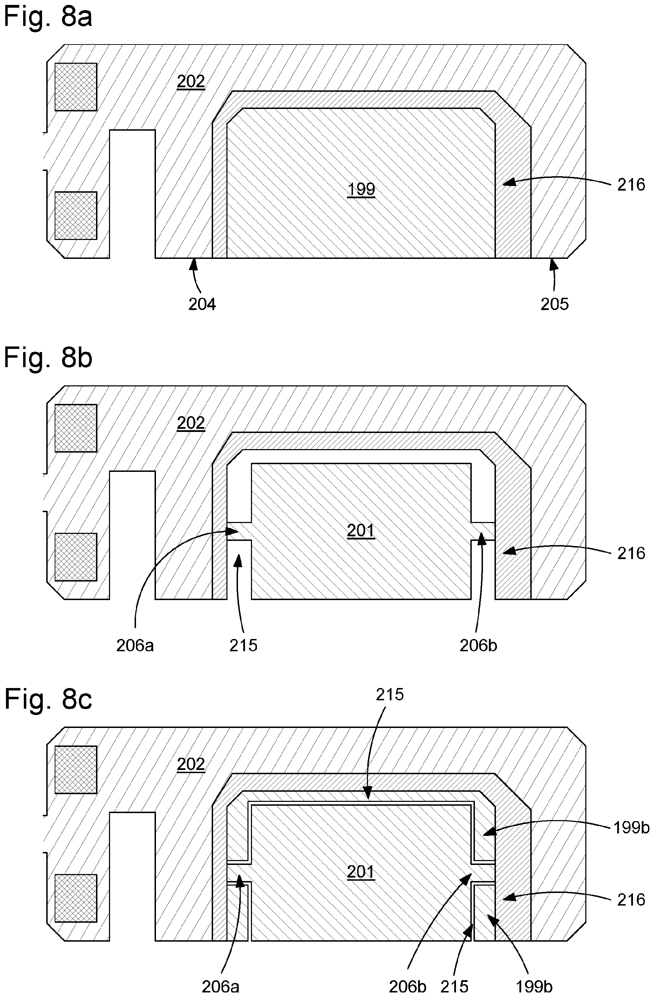

The fig. 8a shows a preformed resonator obtained by chemical wet etching. The preformed resonator comprises the frame 202 and a wet etched planar portion 199 which has a substantially constant thickness inferior to the thickness of the frame 202. Due to the anisotropy of the chemical wet etching, the preformed resonator may further comprise intermediate portions 216 of gradually changing thicknesses between the frame 202 and the planar portion 199.

The figure 8b shows an embodiment of a resonator obtained by a manufacturing process according to the first embodiment wherein the process comprises a step of chemical wet etching of the planar portion 199 of the preformed resonator described hereinabove in relation with the fig. 8a to form the resonator plate 201 and the tethers 206a, 206b. In order to obtain well defined shapes, the formation of a minimum gap 215 width between the resonator plate 201 and the intermediate portions 216 is required. For example the minimum gap has a width of more than 20 µm, preferably at least 50 µm, more preferably at least 75 µm. Advantageously, the resonator plate 201 thereby obtained has a smaller area compared to the initial area of the planar portion 199, such as to ensure a constant thickness of the resonator plate 201 and to minimize its defects.

In a second embodiment, the process for manufacturing a resonator comprises the steps of :
- Providing a wafer of ZT-cut quartz and applying a first mask on the surface of the wafer for covering a first surface destined to form a frame 202 with a C-shaped portion, and leaving a portion of the surface of the wafer uncovered destined to form a thinner planar portion 199 of the wafer;
- Cutting by femtosecond laser or by deep reactive ion etching (DRIE) the contour of a resonator plate 201 with tethers 206a, 206b extending from the resonator plate to the C-shaped portion of the frame 202.

The figure 8c shows embodiment of a resonator obtained by a manufacturing process according to a second embodiment wherein the process comprises cutting the planar portion 199 of the preformed resonator of fig. 8a by deep reactive ion etching (DRIE) or by femtosecond laser to form the resonator plate 201 and the tethers 206a, 206b. The cutout of the planar portion 199 to form the resonator plate 201 and the tethers 206a, 206b may be limited to contouring the resonator plate and the tethers, without the need of removing the residual planar portion 199b attached to the intermediate portion 216. DRIE or femtosecond laser allows cutting well defined shapes and for proper oscillation of the plate, it is sufficient to leave a gap 215 around the resonator plate 201 and the tethers 206a, 206b of at least about 1 µm, preferably at least about 5 µm. Advantageously, the resonator plate 201 thereby obtained has a smaller area compared to the initial area of the planar portion 199, such as to ensure a constant thickness of the resonator plate 201 and to minimize its defects.

In one aspect of the invention, a process for manufacturing a resonator according to a third embodiment comprises the steps of:
- Providing a wafer of ZT-cut quartz, and ;
- Cutting by femtosecond laser or by deep reactive ion etching (DRIE) the contour of a resonator plate 201 with tethers 206a, 206b extending from the resonator plate to the C-shaped portion of the frame 202.

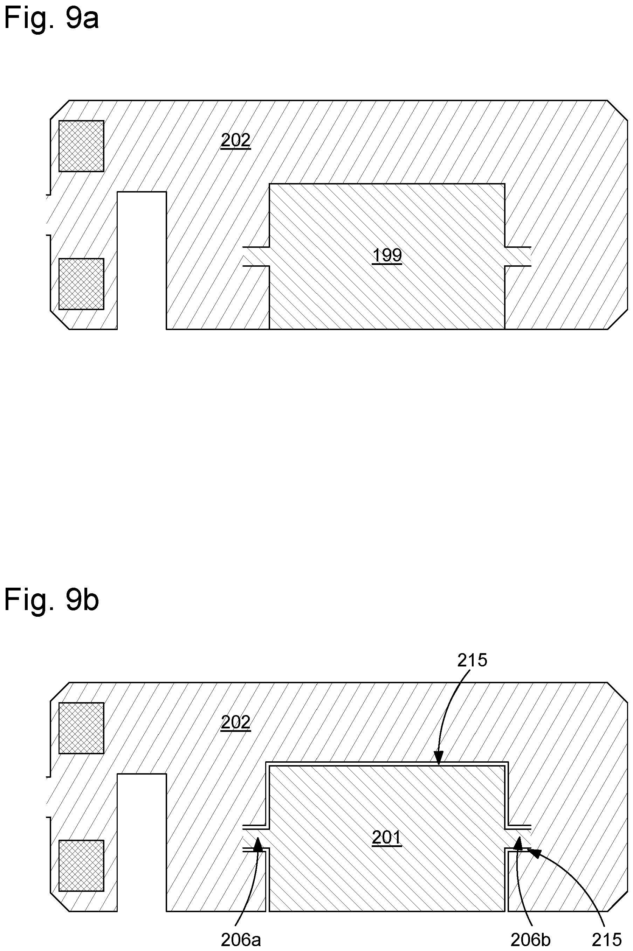

The figure 9a shows a preformed resonator according to another embodiment, wherein the preformed resonator comprises a frame 202 and a planar portion 199a which can have both the same thickness as the frame 202 or wherein the planar portion 199a can have been made thinner with respect to the thickness of the frame 202 by a physical etching process such as by DRIE or femtosecond laser treatment, resulting to frame's sidewalls forming substantially right angles with the planar portion 199. No etch-residues are formed by this technique, and the cutout of the contours of the resonator plate 201 and the tethers 206a, 206b can be made by DRIE or femtosecond laser, leaving a small gap between the frame 202 and the group of resonator plate 201 ant the tethers 206a, 206b, with the exception of tether's ends attached to the frame 202. For proper oscillation of the plate, it is sufficient to leave a gap 215 around the resonator plate 201 and the tethers 206a, 206b of at least about 1 µm, preferably at least about 5 µm.

Any one of the manufacturing process described above can comprise a step of forming a notch in the frame to obtain a mounting portion and a C-shaped portion.

In any one of the process of manufacturing described above, a plurality of resonators can be made on a the same wafer. Advantageously, the deposition of electrodes on the resonator plate, and the deposition of wiring and of mounting pads on the frame can be done while the plurality of the resonators are on the same wafer. Then each resonator on the same wafer can be separated from each other, preferably by femtosecond laser or DRIE.

Frequency-tuning can be achieved by deposition or removal of mass, e.g. by means of evaporation, sputtering or laser-beam, ion-beam etching. As the mass distribution on the resonator plate acts on its thermal properties, a fine tuning of the frequency-temperature behaviour is possible by local ablation or deposition of mass. This can be considered as higher order frequency tuning. Tuning typically acts on the mass of metal layers on the resonator, but may in principle be performed on the quartz directly.

In one non-limitative example according to the present invention, the resonator comprises a resonator plate 201 and a frame 202. The frame 202 fits into a rectangle of 1400 µm x 580 µm and has a thickness of 127 µm. The resonator plate has a thickness of 50 µm and has a width of 330 µm, a maximum length LR1 of 570 µm at the edge of the resonator plate and a second length LR2 at the central longitudinal axis of 560 µm. The frame comprises a C-shaped portion 203 comprising a first arm 204 and a second arm 205 with a first tether 206a and a second tether 206b connecting the resonator plate 201 to the frame 202. The tethers 206a, 206b and the resonator plate 201 have a thickness of 50 µm. The tethers 206a, 206b both have a width of 50 µm, and a length of 90 µm. The resonator plate 201 comprises a couple of first electrodes 208, 208' connected to a first mounting pad 210, and a second couple of electrodes 209, 209' connected to a second mounting pad 211 as described in relation with the embodiment of fig. 4a above.

The mounting pads are arranged on a mounting portion of the frame connected to the C-shaped portion by a stem coplanar to the mounting portion and the C-shaped portion and forming a notch there between.

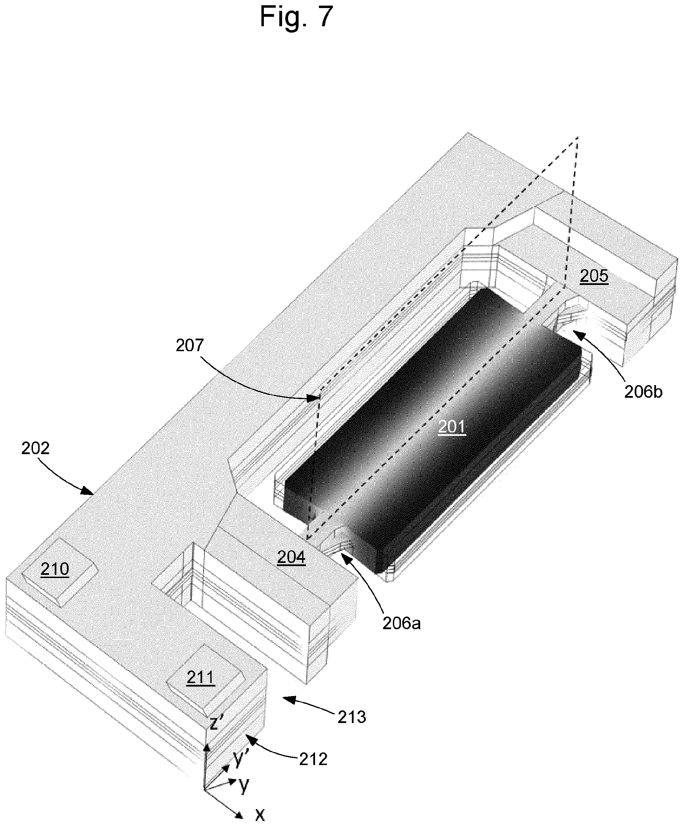

Figure 7 shows an image of simulation of a resonator according to an embodiment of the invention wherein the geometry is optimized in order to minimize residual coupling to the tethers and the frame. On the simulation image, the darker areas represent areas of the resonator plate wherein the extensional deformations of the resonator plate 201 on both sides of the nodal plane 207 are the most important. The clearer areas represent areas wherein the deformations are at their minimum. As it can be seen, in the area of the resonator plate 201 close to the nodal plane and on the tethers 206a, 206b, amplitudes of vibration are at their minimum or zero. Therefore, while the resonator is in use, i.e. when the resonator plate is submitted to an alternative electric field, the tethers 206a, 206b and the area of the resonator plate 201 close to the nodal plane 207 are immobile relative to the frame 202.

According to the present invention, it has been made possible to reduce the size of a ZT-cut quartz resonator, by providing a resonator plate of a simpler shape easier to machine and with more stable fixations.

### Nomenclature

100 prior art resonator
101 first resonator plate
102 second resonator plate
103 resonant arm
104 mounting portion
105 suspension arm
199 planar portion of preformed resonator
199b residues of planar portion
200 resonator
201 resonator plate
202 frame
203 C-shaped portion
204 first arm
205 second arm
206a/206b tethers
207 nodal plane
208 first electrode
209 second electrode
208' third electrode
209' fourth electrode
210 first mounting pad
211 second mounting pad
212 mounting portion
213 notch
214 piezoelectric layer
215 space between frame and resonator plate
216 etch residues
TR Thickness of resonator
TF thickness of frame
SR surface of resonator
SR1 first side of SR
SR2 second side of SR
LR1 maximum length of the resonator
LR2 second length of the resonator
WR width of the resonator
WC central width of the resonator

## Claims

1. Resonator 200 comprising :
- a resonator plate 201 having a thickness TR, and a surface SR having a maximum length LR1 and a width WR, wherein the resonator plate 201 is a ZT-cut quartz ;
- a frame 202 comprising a C-shaped portion 203 comprising a first arm 204, and a second arm 205 extending at least partially about the width edges of the resonator plate and wherein each arm 204, 205 is connected to the resonator plate by means of tethers 206a, 206b.

2. Resonator according to claim 1 wherein is defined a nodal plane 207 orthogonal to the surface SR of the resonator plate 201 and passing through a central longitudinal axis of the resonator plate 201 and wherein the tethers 206a, 206b pass through the nodal plane 207.

3. Resonator according to claim 1 or 2 wherein the resonator plate 201 is configured to oscillate in the direction of its width WR on both sides of a nodal plane 207, and the C-shaped portion 203 of the frame 202 is spaced from the resonator plate 201 such as to prevent the resonator plate 201 to enter into contact with the frame 202 while the resonator plate 201 is oscillating.

4. Resonator according to any one of the preceding claims wherein the resonator plate 201 comprises at least a first electrode 208 and a second electrode 209 separated from each other and electrically coupled respectively to a first mounting pad 210 and to a second mounting pad 211 arranged on the frame 202, the electrodes 208, 209 being arranged on the resonator plate 201 such as to create an electric field between two opposite surfaces of the resonator plate, on both sides of the nodal plane 207.

5. Resonator according to any one of the preceding claims wherein a first electrode 208 and a second electrode 209 are arranged on the resonator plate 201, such as to provide a deformation of the resonator plate along the width of the resonator plate when the first electrode and the second electrode are coupled to an alternative voltage creating an alternative electric field between the two electrodes.

6. Resonator according to any one of the preceding claims wherein the tethers 206a, 206b are integral with the resonator plate 201 and the frame 202, a first tether 206a extending between the resonator plate 201 and a first arm 204 of the C-shaped portion 203, and a second tether 206b extending between the resonator plate 201 and a second arm 205 of the C-shaped portion 203 of the frame 201.

7. Resonator according to any one of the preceding claims wherein the resonator plate 201 comprises a shortest length LR2, the shortest length LR2 extending proximate to a location in between :
- a first corner formed between a first tether and a first lateral edge of the resonator plate, and ;
- a second corner formed between a second tether and a second lateral edge of the resonator plate.

8. Resonator according to claim 7 wherein the shortest length LR2 is at least 90% of the maximum length LR1, preferably at least 95% of the maximum length LR1, more preferably at least 98% of the maximum length LR1.

9. Resonator according to any one of the preceding claims wherein the resonator plate 201 is substantially symmetrical with respect to its median width axis MW and with respect to its central longitudinal axis coinciding with the nodal plane 207.

10. Resonator according to any one of the preceding claims wherein the frame 202 has a frame thickness TF, and the resonator has a resonator thickness TR which is comprised between 25% and 100%, preferably between 25% and 75%, more preferably between 25% and 50% of the frame thickness TF, preferably wherein the maximum thickness of the frame TF is inferior or equal to 200 µm, preferably inferior or equal to 150 µm, more preferably inferior or equal to 120 µm.

11. Resonator according to any one of the preceding claims wherein the resonator plate 201 has a maximum length inferior or equal to 2500 µm, preferably inferior or equal to 1000 µm, more preferably inferior or equal to 600 µm.

12. Resonator according to any one of the preceding claims wherein the resonator plate 201 has a maximum width WR such that the ratio of the (maximum width WR)/ (maximum length LR1) is comprised from between 0.4 to 0.8, preferably from 0.5 to 0.7.

13. Resonator according to any one of the preceding claims wherein the frame 202 comprises a mounting portion 212 comprising the first mounting pad 210 and the second mounting pad 211, the mounting portion 212 extending substantially parallel to the arms 204, 205 of the C-shaped portion 203, the mounting portion 212 being connected to the C-shaped portion 203 and forming a notch 213 with the C-shaped portion 203.

14. Resonator according to any one of the preceding claims wherein the tethers have :
- a length comprised between 10 µm and 300 µm, preferably 20 to 150 µm, more preferably 40 µm to 100 µm, and/or;
- a width of 25% or less of the width of the resonator plate, and/or;
- a thickness comprised between 50% to 150% of the thickness of the resonator plate.

15. Manufacturing process of a ZT-cut resonator, wherein the process comprises the steps of:
- providing a ZT-cut wafer;
- defining a resonator shape emplacement on the wafer, wherein the resonator shape emplacement includes a resonator frame shape emplacement, a resonator plate shape emplacement and tethers shape emplacements, wherein the tethers shape emplacements are positioned along a central longitudinal axis of the resonator plate shape emplacement and links the lateral sides of the resonator plate shape emplacement to the resonator frame shape emplacement;
- etching a portion of the wafer to obtain the contours of a resonator plate with tethers on both lateral sides of the resonator plate and such that the tethers remains integral with the resonator frame ;
- depositing:
∘ at least two separated electrodes on the resonator plate such that a first electrode has a main portion arranged on one side of a plane passing through the tethers and a second electrode has a main portion arranged on the other side of the plane passing through the tethers;
∘ two mounting pads on the resonator frame emplacement, and ;
∘ connecting tracks connecting each electrode to a respective mounting pad, and ;
- etching the contours of the resonator frame emplacement such as to obtain a resonator.
